# EUROPÄISCHE PATENTANMELDUNG

(11) **EP 1 170 799 A2**
(43) Veröffentlichungstag der Anmeldung: **09.01.2002**
(21) Anmeldenummer: 01113210.7
(22) Anmeldetag: 30.05.2001
(51) Int. Cl.: H01L 27/115, H01L 21/8247, H01L 51/30

(54) **Elektronisches Bauelement und Verfahren zum Herstellen eines elektronischen Bauelements**

(30) Priorität: 04.07.2000 DE 10032413
(71) Anmelder: Infineon Technologies AG, 81669 München (DE)
(72) Erfinder: Hofmann, Franz, Dr., 80995 München (DE); Kreupl, Franz, Dr., 80469 München (DE); Luyken, Richard Johannes, Dr., 81825 München (DE); Schloesser, Till, Dr., 01109 Dresden (DE)
(74) Vertreter: Viering, Jentschura & Partner

(57) **Zusammenfassung**

Ein elektronisches Bauelement weist mehrere elektrisch leitende erste Nanodrähte auf, ein auf den ersten Nanodrähten aufgebrachtes Schichtensystem sowie auf dem Schichtensystem aufgebrachte zweite Nanodrähte. Die ersten und zweiten Nanodrähte sind zueinander windschief angeordnet. Das Schichtensystem ist derart eingerichtet, dass von den Nanodrähten erzeugte Ladungsträger in dem Schichtensystem gespeichert werden können.

## Beschreibung

Die Erfindung betrifft ein elektronisches Bauelement und ein Verfahren zum Herstellen eines elektronischen Bauelements.

Aus [1] ist ein elektronisches Bauelement, ein sogenannter Flash-Speicher bekannt. Bei einem solchen Flash-Speicher können vorgegebene Daten in binärer Form gespeichert und ausgelesen werden.

Weiterhin sind aus [2] Grundlagen über sogenannte Carbon-Nanoröhren bekannt.

Ein Verfahren zum Herstellen von Carbon-Nanoröhren, die im weiteren auch als Kohlenstoff-Nanoröhren bezeichnet werden, durch Aufwachsen der Kohlenstoff-Nanoröhren auf einem Substrat, ist aus [3] bekannt.

Ein weiteres Herstellungsverfahren zum Herstellen von Kohlenstoff-Nanoröhren durch Abscheiden der Kohlenstoff-Nanoröhren aus der Gasphase ist in [3] beschrieben.

Weiterhin ist aus [4] ein Schichtensystem bekannt, aufweisend eine erste Siliziumdioxid-Schicht, eine darauf aufgebrachte Siliziumnitrid-Schicht und eine zweite, auf der Siliziumnitrid-Schicht aufgebrachte Siliziumdioxid-Schicht. Ein solches Schichtensystem wird auch als ONO-Schichtensystem bezeichnet.

In [4] ist ferner beschrieben, dass die Siliziumnitrid-Schicht die Eigenschaft analog zu einem "Floating Gate" aufweist, d.h., dass Ladungsträger, die durch die erste Siliziumdioxid-Schicht oder durch die zweite Siliziumdioxid-Schicht in die Siliziumnitrid-Schicht gelangt sind, dort eine sehr lange Zeitdauer (einige Jahre und länger) gespeichert werden können.

Weiterhin ist es aus [5] bekannt, sogenannte Quantendots in einer Schicht zu bilden.

In [6] ist ein Verfahren zum Speichern und Auslesen von binären Daten in eine bzw. aus einer Flash-Speicherzelle beschrieben. Insbesondere ist das Funktionsprinzip einer NAND Auslesung erläutert.

In [7] wird ein auf Nanodrähten basierendes Bauelement vorgeschlagen, wobei die Nanodrähten einander kreuzend in dem Bauelement übereinander angeordnet sind.

Der Erfindung liegt das Problem zugrunde, ein elektronisches Bauelement sowie ein Verfahren zum Herstellen eines elektronischen Bauelements anzugeben, mit dem ein Speicher-Bauelement gebildet werden kann, welches gegenüber dem aus [1] bekannten Flash-Speicher eine bei gleicher Anzahl von Speicherzellen geringere Größe aufweist.

Das Problem wird durch das elektronische Bauelement sowie durch das Verfahren zum Herstellen eines elektronischen Bauelements mit den Merkmalen gemäß den unabhängigen Patentansprüchen gelöst.

Ein elektronisches Bauelement weist mindestens einen elektrisch leitenden ersten Nanodraht sowie ein auf dem ersten Nanodraht aufgebrachtes Schichtensystem auf. Auf dem Schichtensystem ist mindestens ein zweiter Nanodraht aufgebracht, wobei der erste Nanodraht und der zweite Nanodraht zueinander windschief angeordnet sind. Das Schichtensystem ist derart ausgestaltet, dass von dem ersten Nanodraht und/oder dem zweiten Nanodraht erzeugte Ladungsträger in dem Schichtensystem gespeichert werden können.

Durch den Einsatz von Kohlenstoff-Nanoröhren, allgemein von Nanodrähten, wird es auf sehr einfache Weise möglich, die Größe des durch das elektronische Bauelement gebildeten elektronischen Speicherelements erheblich zu reduzieren.

Werden beispielsweise Kohlenstoff-Nanoröhren mit einem Durchmesser von einem Nanometer und einer Länge von 10 µm im Abstand von 20 nm einander angeordnet, wird die Fläche, die für ein Elementar-Zellenfeld zum Speichern eines Bits gegenüber der erforderlichen Fläche des aus [1] bekannten Flash-Speichers, um den Faktor 500 und mehr verringert.

Ein weiterer erheblicher Vorteil der Erfindung ist darin zu sehen, dass keine Gate-Elektroden mehr strukturiert werden müssen, sondern dass die Schichten des Schichtensystems ganzflächig aufgebracht werden können. Somit ist eine Strukturierung eines Floating Gates mit einer sehr hohen örtlichen Auflösung von einigen Nanometern nicht mehr erforderlich.

Der zweite Nanodraht kann elektrisch halbleitend ausgestaltet sein.

Das elektrische Speicherelement kann sowohl eine Mehrzahl elektrisch leitender erster Nanodrähte als auch eine Mehrzahl zweiter Nanodrähte aufweisen, die jeweils zueinander windschief angeordnet sind.

Gemäß dieser Ausgestaltung der Erfindung wird anschaulich eine Speicher-Matrix in entsprechender Weise wie bei dem bekannten Flash-Speicher gebildet.

Der zweite Nanodraht kann ein Silizium-Nanodraht oder ein Bor-Nitrid-Nanodraht sein. Allgemein können der erste Nanodraht und/oder der zweite Nanodraht Gold, Silber, Wolfram, Kupfer, Tantal und/oder Titan oder eine beliebige Legierung mehrerer der zuvor genannten Metalle, allgemein jedes elektrisch leitende bzw. halbleitende Material, enthalten.

Gemäß einer weiteren Ausgestaltung der Erfindung ist/sind der erste Nanodraht und/oder der zweite Nanodraht eine bzw. mehrere Kohlenstoff-Nanoröhren.

Unter einem Nanodraht ist somit im weiteren eine Struktur zu verstehen, die im wesentlichen eine Dicke aufweist, die ungefähr gleich ist dem Durchmesser einer Kohlenstoff-Nanoröhre.

Als Schichtensystem kann das sogenannte ONO-Schichtensystem eingesetzt werden, d.h. ein Schichtensystem mit einer ersten Siliziumdioxid-Schicht und einer auf der ersten Siliziumdioxid-Schicht aufgebrachten Siliziumnitrid-Schicht. Auf der Siliziumnitrid-Schicht ist eine zweite Siliziumdioxid-Schicht aufgebracht.

Das ONO-Schichtensystem bildet anschaulich ein Floating Gate, wobei in der Siliziumnitrid-Schicht elektrische Ladungsträger, die die erste Siliziumdioxid-Schicht oder die zweite Siliziumdioxid-Schicht durchdringen, gespeichert werden.

Bei einer Mehrzahl von ersten und zweiten Nanodrähten und bei Einsatz eines ONO-Schichtensystems ist gemäß einer Weiterbildung der Erfindung vorgesehen, die ersten Nanodrähte und die zweiten Nanodrähte jeweils derart zueinander anzuordnen, dass der Abstand zwischen zwei ersten Nanodrähten bzw. zwischen zwei zweiten Nanodrähten jeweils mindestens doppelt so groß ist wie der Abstand der zweiten Nanodrähte zu der Siliziumnitrid-Schicht in dem ONO-Schichtensystem.

Die Funktion eines Floating Gates kann auch dadurch realisiert werden, dass in dem Schichtensystem Quantendots als künstliche Störstellen zum Speichern von elektrischen Ladungsträgern gebildet werden. Die Quantendots können Polysilizium enthalten.

Gemäß einer weiteren Ausgestaltung der Erfindung weisen die ersten Nanodrähte und/oder die zweiten Nanodrähte mehrere zylinderförmige Wände auf, die konzentrisch umeinander angeordnet sind.

Durch diese Weiterbildung wird die Stabilität der Nanodrähte, insbesondere hinsichtlich einer möglichen Reaktion mit einem sich zwischen den Nanodrähten möglicherweise befindenden Dielektrikum, erhöht, wodurch die Zuverlässigkeit des elektronischen Bauelements erheblich verbessert wird.

Anschaulich kann die Erfindung darin gesehen werden, dass jeder zweite Nanodraht eine Serienschaltung von Transistoren darstellt, bei denen die ersten Nanodrähte anschaulich als Gate-Elektroden verwendet werden können. Die Störstellen, die sich in dem Schichtensystem bilden zum Speichern der erzeugten Ladungsträger dienen dazu, die Einsatzspannung des elektronischen Bauelements zu verschieben.

Auf diese Weise werden durch das elektronische Bauelement gemäß der Erfindung zwei, voneinander unterscheidbare Zustände auf einfache Weise generierbar, wodurch das elektronische Bauelement als binäres Speicherelement verwendet werden kann. Diese zwei Zustände sind charakterisiert durch einen ersten Zustand, in dem die Einsatzspannung des elektronischen Bauelements nicht verschoben ist und einen zweiten Zustand, in dem die Einsatzspannung des elektronischen Bauelements verschoben ist.

Zum Speichern und zum Auslesen der Daten kann das in [6] beschriebene Funktionsprinzip der NAND-Auslesung eingesetzt werden. Die metallischen Topelektroden, die an den Nanodrähten vorgesehen sein können, werden sowohl zum Laden der Störstellen verwendet, d.h. dem Schreiben mit hoher Spannung als auch direkt beim Lesen der Daten, wobei die nicht auszulesenden Bereiche durch Feldeffekt durchgeschaltet werden.

Das oben dargestellte elektronische Bauelement kann hergestellt werden, indem eine Mehrzahl elektrisch leitender erster Nanodrähte nebeneinander angeordnet werden. Auf den ersten Nanodrähten wird mindestens ein Schichtensystem aufgebracht. Auf dem Schichtensystem wird ferner eine Mehrzahl zweiter Nanodrähte nebeneinander und windschief zu den ersten Nanodrähten angeordnet.

Das Schichtensystem kann beispielsweise dadurch hergestellt werden, dass auf den ersten Nanodrähten eine Siliziumdioxid-Schicht aufgebracht wird, beispielsweise mittels eines CVD-Verfahrens (Chemical Vapour Deposition-Verfahren), eines Sputter-Verfahrens, eines Aufdampf-Verfahrens. Auf der Siliziumdioxid-Schicht wird gemäß dieser Ausgestaltung eine Siliziumnitrid-Schicht aufgebracht, wiederum beispielsweise mittels eines CVD-Verfahrens, eines Sputter-Verfahrens oder eines Aufdampf-Verfahrens.

Auf der Siliziumnitrid-Schicht wird eine zweite Siliziumdioxid-Schicht aufgebracht, beispielsweise auf die gleiche Weise wie die erste Siliziumdioxid-Schicht.

Zusätzlich kann, zu Beginn des Verfahrens, auf den ersten Nanodrähten eine weitere Siliziumnitrid-Schicht aufgebracht werden, insbesondere zum Schutz der Nanodrähte vor Temperatureinflüssen, insbesondere auch vor deren Zerstörung im Rahmen eines CVD-Verfahrens oder eines anderen Verfahrens, bei dem die Nanodrähte einer erhöhten Temperatur ausgesetzt sind.

Die Nanodrähte können auf unterschiedliche Weise hergestellt werden, beispielsweise mittels eines Abscheideverfahrens aus der Gasphase (**C**hemical **V**apour **D**eposition-Verfahren, CVD-Verfahren), wie es z.B. in [3] beschrieben ist, oder auch im Lichtbogenverfahren oder mittels Laserablation.

Die Nanodrähte aus einem Metall können mittels bekannter Verfahren, beispielsweise mittels eines CVD-Verfahrens, eines Sputter-Verfahrens oder eines Aufdampf-Verfahrens hergestellt werden.

Die Nanodrähte, insbesondere die Kohlenstoff-Nanoröhren können beispielsweise unter Verwendung eines oder mehrer elektrischer Felder in der gewünschten Weise angeordnet und ausgerichtet werden.

Alternativ kann deren Anordnung, bzw. die Ausrichtung der Nanodrähte, auch durch mechanische Einwirkung, beispielsweise durch Rütteln oder spezifisches Anordnen und Ausrichten der Nanodrähte erfolgen.

Weiterhin können sogenannte Nano-Poren gemäß einer alternativen Ausgestaltung der Erfindung verwendet werden zum Anordnen der Nanodrähte, insbesondere zum Anordnen der Kohlenstoff-Nanoröhren.

Die Anordnung der ersten Nanoröhren kann alternativ ebenso wie die Anordnung der zweiten Nanoröhren unter Verwendung eines Rasterkraftmikroskops auf bekannte Weise erfolgen.

Ferner können mehrere Schichtensysteme stapelförmig übereinander angeordnet sein, wobei jeweils zwischen zwei Schichtensystemen abwechselnd ein oder mehrere erster Nanodrähte und ein oder mehrere zweiter Nanodrähte angeordnet sind. Auf diese Weise wird eine weitere Reduktion des benötigten Platzbedarfs erzielt, da anschaulich jeweils nur noch eine "Schicht" von ersten Nanodrähten erforderlich ist zur Steuerung von "Schichten" mit zweiten Nanodrähten.

Durch die oben beschriebene Stapelung der Schichtensysteme ist eine weitere Verdoppelung der Speicherkapazität bei gleichbleibender benötigter Speicherfläche erreichbar.

Ausführungsbeispiele der Erfindung sind in den Figuren dargestellt und werden im weiteren näher erläutert.

Es zeigen:
- Figur 1: eine Draufsicht auf ein elektronisches Bauelement gemäß einem ersten Ausführungsbeispiel der Erfindung von schräg oben;
- Figur 2: einen Querschnitt eines elektronischen Bauelements gemäß einem ersten Ausführungsbeispiel der Erfindung;
- Figur 3: einen Querschnitt durch ein elektronisches Bauelement gemäß einem zweiten Ausführungsbeispiel der Erfindung;
- Figur 4: einen Querschnitt durch ein elektronisches Bauelement gemäß einem dritten Ausführungsbeispiel der Erfindung;
- Figur 5: einen Querschnitt durch ein elektronisches Bauelement gemäß einem vierten Ausführungsbeispiel der Erfindung.

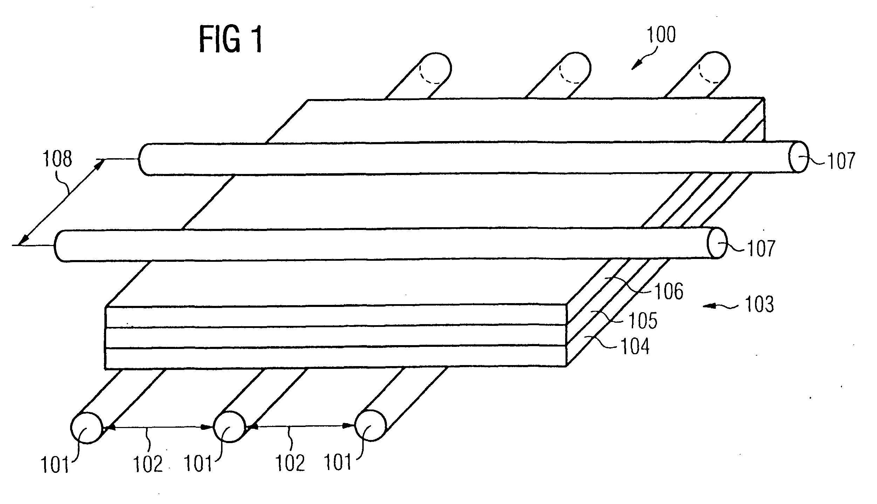

**Fig.1** zeigt ein elektronisches Bauelement 100 gemäß einem ersten Ausführungsbeispiel der Erfindung.

Das elektronische Bauelement 100, gemäß dem ersten Ausführungsbeispiel ein elektronischer Speicher, weist erste elektrisch halbleitende Kohlenstoff-Nanoröhren 101 auf.

Die ersten Kohlenstoff-Nanoröhren 101 werden mittels eines Abscheideverfahrens aus der Gasphase, wie es in [3] beschrieben ist, hergestellt.

Die hergestellten, halbleitenden ersten Kohlenstoff-Nanoröhren 101 werden ausgewählt und die ausgewählten ersten Kohlenstoff-Nanoröhren, die als elektrisch halbleitende Kohlenstoff-Nanoröhren bestimmt worden sind, werden in einem vorgegebenen Abstand 102 voneinander auf einer im wesentlichen planaren Oberfläche, beispielsweise einem Substrat (nicht dargestellt), angeordnet.

Der Abstand zwischen zwei halbleitenden Kohlenstoff-Nanoröhren 101, die als erste Nanodrähte dienen, beträgt mindestens 5 nm bis 7 nm angeordnet.

Die Anordnung der ersten Kohlenstoff-Nanoröhren 101 und deren zueinander im wesentlichen parallele Ausrichtung wird erreicht durch Verwenden, d.h. Anlegen eines elektrischen Feldes, mit dem die ersten Kohlenstoff-Nanoröhren 101 ausgerichtet werden.

Es ist in diesem Zusammenhang anzumerken, dass die Kohlenstoff-Nanoröhren nicht unbedingt parallel zueinander ausgerichtet sein müssen, es ist lediglich von Bedeutung, dass die ersten Kohlenstoff-Nanoröhren 101 einander in dem elektronischen Bauelement 100 nicht schneiden.

Auf den ersten Kohlenstoff-Nanoröhren 101 wird ein Schichtensystem 103 aufgebracht.

Das Schichtensystem 103 ist ein ONO-Schichtensystem, d.h. es weist eine erste Siliziumdioxid-Schicht 104, eine darauf aufgebrachte Siliziumnitrid-Schicht 105 und eine auf der Siliziumnitrid-Schicht 105 aufgebrachte zweite Siliziumdioxid-Schicht 106 auf.

Das ONO-Schichtensystem wird hergestellt, indem eine erste Siliziumdioxid-Schicht 104 auf den ersten Kohlenstoff-Nanoröhren 101 aufgebracht wird, gemäß diesem Ausführungsbeispiel, mittels eines Sputter-Verfahrens. Die Dicke der ersten Siliziumdioxid-Schicht 104 beträgt 2,4 nm bis 3,5 nm.

Auf der ersten Siliziumdioxid-Schicht 104 wird eine Siliziumnitrid-Schicht 105 der Dicke von 4 nm mittels eines CVD-Verfahrens bei einer Temperatur von 700 °C abgeschieden.

In einem weiteren Schritt wird auf der Siliziumnitrid-Schicht 105 eine zweite Siliziumdioxid-Schicht der Dicke von ungefähr 4,5 nm mittels einer bei 900 °C stattfindenden Nass-Oxidation aufgebracht.

Auf der zweiten Siliziumdioxid-Schicht 106 sind zweite, elektrisch metallisch leitende Kohlenstoff-Nanoröhren 107 angeordnet.

Die zweiten Kohlenstoff-Nanoröhren 107 werden ebenfalls aus der Gasphase abgeschieden, wie in [3] beschrieben, mittels eines geeigneten CVD-Verfahrens. Aus den abgeschiedenen Kohlenstoff-Nanoröhren werden die metallisch leitenden, zweiten Kohlenstoff-Nanoröhren 107 ausgewählt und auf die zweite Siliziumdioxid-Schicht 106 aufgebracht und mittels eines elektrischen Felds in vorgegebener Weise ausgerichtet.

Anschaulich stellt jede erste, elektrisch halbleitende Kohlenstoff-Nanoröhre 101 eine Serienschaltung von Transistoren dar, die durch die metallisch leitenden, zweiten Kohlenstoff-Nanoröhren 107 als Gate-Elektroden gesteuert werden.

Störstellen in der Siliziumnitrid-Schicht 105 bilden anschaulich ein Floating Gate, wodurch bei Besetzen der Störstellen mit elektrischen Ladungsträgern die Einsatzspannung des elektrischen Bauelements 100, d.h. insbesondere des Bereichs, in dem sich die Störstellen insbesondere befinden, verschoben wird.

Auf diese Weise bildet das elektronische Bauelement 100 einen binären Permanentspeicher, da durch Anlegen einer Schreib-Spannung mittels einer Peripherie-Schaltung (nicht dargestellt), welche Schreib-Spannung größer ist als die Betriebsspannung, zwischen einer ersten Kohlenstoff-Nanoröhre 101 und einer zweiten Kohlenstoff-Nanoröhre 107 elektrische Ladungsträger in die Siliziumnitrid-Schicht 105 injiziert und dort gespeichert, d.h. "festgehalten" werden.

Zum Schreiben und Auslesen der binären Daten wird das in [6] beschriebene Funktionsprinzip der NAND-Auslesung eingesetzt.

Dabei werden die metallischen Topelektroden, die an den Nanodrähten vorgesehen sind, sowohl zum Laden der Störstellen verwendet, d.h. dem Schreiben mit hoher Spannung als auch direkt zum Lesen der Daten, wobei die nicht auszulesenden Bereiche durch einen auftretenden und erfindungsgemäß genutzten Feldeffekt durchgeschaltet werden.

Während dieses "Schreib-Vorgangs" werden die weiteren halbleitenden ersten Kohlenstoff-Nanoröhren 101 auf eine vorgegebene Referenzspannung gelegt, so dass der zum Injizieren der elektrischen Ladungsträger in die Siliziumnitrid-Schicht 105 nötige Spannungsabfall nur an der Kreuzungsstelle der ersten Kohlenstoff-Nanoröhre 101 und der zweiten Kohlenstoff-Nanoröhre 107, die einander an der jeweiligen Kreuzungsstelle übereinanderliegen, anliegt.

Sollen die injizierten elektrischen Ladungsträger aus der Siliziumnitrid-Schicht an der entsprechenden Kreuzungsstelle wieder gelöscht werden, so ist dies möglich durch Anlegen der entsprechend umgepolten elektrischen Spannung zwischen der jeweiligen ersten Kohlenstoff-Nanoröhre 101 und der jeweiligen zweiten Kohlenstoff-Nanoröhre 107.

Soll nun der Zustand einer durch jeweils eine Kreuzungsstelle einer ersten Kohlenstoff-Nanoröhre und einer zweiten Kohlenstoff-Nanoröhre 107 ermittelt, d.h. ausgelesen werden, so wird überprüft, ob die Störstellen in der Siliziumnitrid-Schicht 105 zwischen der Kreuzungsstelle der ersten Kohlenstoff-Nanoröhre 101 und der zweiten Kohlenstoff-Nanoröhre 107 mit elektrischen Ladungsträgern besetzt sind, wodurch die Transistoreinsatzspannung verschoben wäre.

Die Ansteuerung und das Auslesen der einzelnen Speicherzellen, die durch die Kreuzungsstelle der ersten Kohlenstoff-Nanoröhren 101, der zweiten Kohlenstoff-Nanoröhren 105 und der dazwischenliegenden ONO-Schichten 103 gebildet wird, folgt durch übliche, hier nicht detailliert erläuterte CMOS-Schaltungstechnik in der in [6] beschriebenen Weise.

Um eine Überlappung der elektrischen Felder zwischen den Kohlenstoff-Nanoröhren 101, 107 zu vermeiden, beträgt der Abstand 102 zwischen den ersten Kohlenstoff-Nanoröhren 101 und der Abstand 108 zwischen den zweiten Kohlenstoff-Nanoröhren 107 mindestens 5 nm, d.h. der Abstand zwischen den Nanoröhren 107, 108 ist doppelt so groß wie der Abstand der ersten Kohlenstoff-Nanoröhren 101 von der unteren Oberfläche der Siliziumnitrid-Schicht 105.

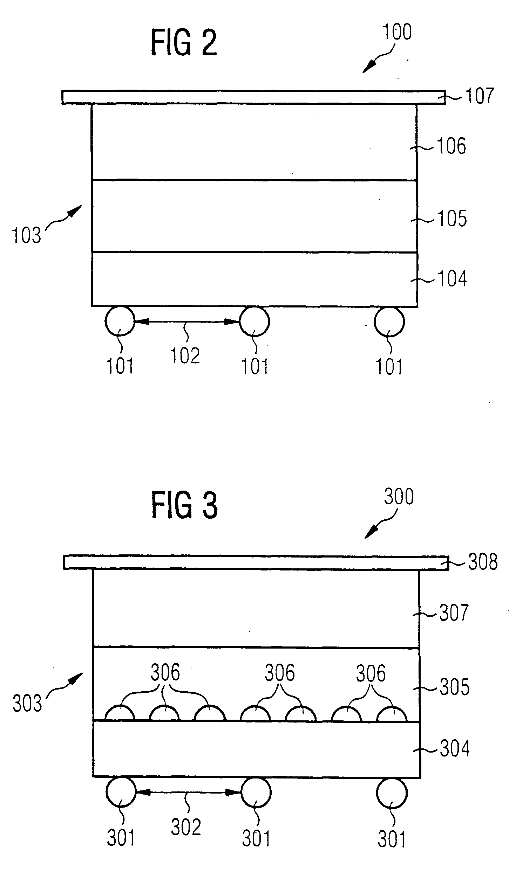

**Fig.2** zeigt einen Querschnitt durch das elektronische Bauelement 100 gemäß dem ersten Ausführungsbeispiel, wobei die gleichen Elemente in **Fig.1** und **Fig.2** mit gleichen Bezugszeichen versehen sind.

In **Fig.3** ist ein Querschnitt eines elektronischen Bauelements 300 gemäß einem zweiten Ausführungsbeispiel dargestellt.

Die ersten Kohlenstoff-Nanoröhren 301 sind in einem Abstand 302 von mindestens 5 nm im wesentlichen parallel zueinander angeordnet.

Auf den ersten Kohlenstoff-Nanoröhren 301 ist ein weiteres Schichtensystem gemäß diesem Ausführungsbeispiel ein Schichtensystem 303 mit einer ersten Siliziumdioxid-Schicht 304 und einer zweiten Siliziumdioxid-Schicht 305 vorgesehen, wobei in der zweiten Siliziumdioxid-Schicht 305 Polysilizium-Dots 306 als künstliche Störstellen gebildet werden, in denen elektrische Ladungsträger, die von den ersten Kohlenstoff-Nanoröhren 301 und/oder den zweiten Kohlenstoff-Nanoröhren 308 erzeugt werden, gespeichert werden können.

Auf der zweiten Siliziumdioxid-Schicht 305 ist eine dritte Siliziumdioxid-Schicht 307 aufgebracht.

Die einzelnen Siliziumdioxid-Schichten 304, 305, 307 können mittels eines CVD-Verfahrens, mittels eines Sputter-Verfahrens oder mittels eines Aufdampf-Verfahrens aufgebracht werden.

Auf der dritten Siliziumdioxid-Schicht 307 sind die zweiten Kohlenstoff-Nanoröhren 308 aufgebracht gemäß der gleichen Vorgehensweise wie bei dem ersten Ausführungsbeispiel.

Das elektronische Bauelement 300 unterscheidet sich somit anschaulich von dem elektronischen Bauelement 100 gemäß dem ersten Ausführungsbeispiel darin, dass als Schichtensystem 303 nicht ein ONO-Schichtensystem verwendet wird, sondern ein Schichtensystem, in dem Polysilizium-Dots vorgesehen sind zum Festhalten, d.h. Speichern elektrischer Ladungsträger.

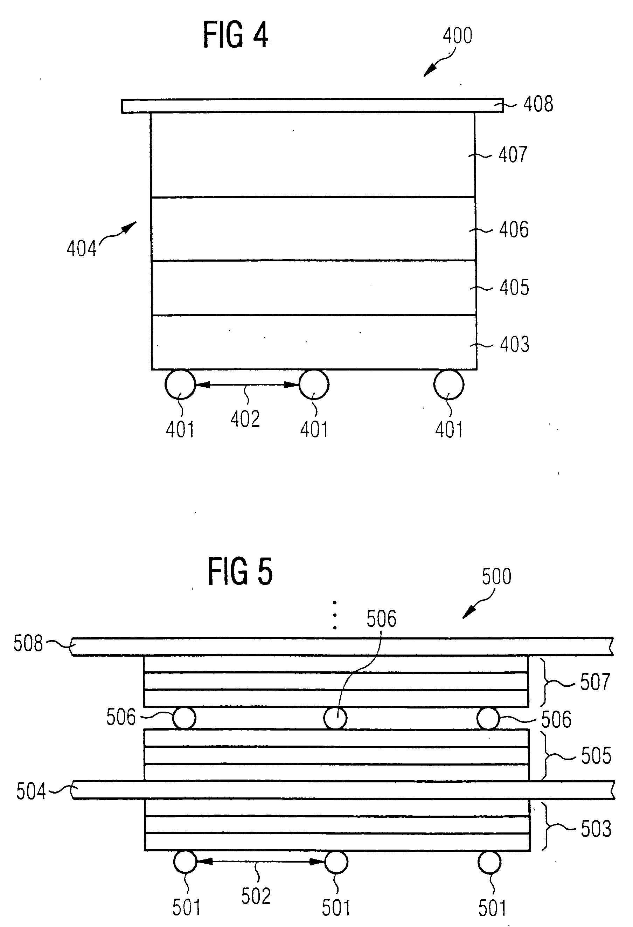

Um beim Aufbringen von dem Schichtensystem 303 möglicherweise auftretende Beschädigungen der ersten Kohlenstoff-Nanoröhren 401 aufgrund hoher Temperaturen während des Herstellungsverfahrens zu vermeiden, ist es gemäß einem dritten Ausführungsbeispiel vorgesehen (vgl. **Fig.4**), auf den ersten Kohlenstoff-Nanoröhren 401, die in einem Abstand 402 von mindestens 5 nm im wesentlichen parallel zueinander angeordnet sind, eine weitere Siliziumnitrid-Schicht 403 aufzubringen, die eine Dicke von 4 nm aufweist.

Auf der weiteren Siliziumnitrid-Schicht 403 ist das Schichtensystem 404, gemäß dem dritten Ausführungsbeispiel wieder ein ONO-Schichtensystem 404 mit einer ersten Siliziumdioxid-Schicht 405, einer darauf aufgebrachten Siliziumnitrid-Schicht 406 und einer auf der Siliziumnitrid-Schicht 406 aufgebrachten zweiten Siliziumdioxid-Schicht 407, aufgebracht.

Auf dem ONO-Schichtensystem 404 sind die zweiten Kohlenstoff-Nanoröhren 408 aufgebracht.

Auf diese Weise ist ein elektronisches Bauelement 400 gemäß einem dritten Ausführungsbeispiel der Erfindung gebildet.

**Fig.5** zeigt ein elektronisches Bauelement 500 gemäß einem vierten Ausführungsbeispiel der Erfindung.

Das elektronische Bauelement 500 gemäß dem fünften Ausführungsbeispiel entspricht im wesentlichen dem elektronischen Bauelement 100 gemäß dem ersten Ausführungsbeispiel mit dem Unterschied, dass eine Vielzahl von ONO-Schichtensystemen vorgesehen sind.

Das elektronische Bauelement 500 weist somit erste Kohlenstoff-Nanoröhren 501 auf, die in einem Abstand 502 von ungefähr 5 nm zueinander im wesentlichen parallel angeordnet sind.

Über den ersten Kohlenstoff-Nanoröhren 501 ist ein erstes ONO-Schichtensystem 503 aufgebracht, auf dem wiederum zweite Kohlenstoff-Nanoröhren 504 aufgebracht sind.

Auf den zweiten Kohlenstoff-Nanoröhren 504 ist ein zweites ONO-Schichtensystem 505 aufgebracht und auf dem zweiten ONO-Schichtensystem 505 wiederum erste Kohlenstoff-Nanoröhren 506.

Auf den ersten Kohlenstoff-Nanoröhren 506 ist ein drittes ONO-Schichtensystem 507 aufgebracht und auf diesem sind wiederum zweite Kohlenstoff-Nanoröhren 508 aufgebracht.

Auf diese Weise ist es anschaulich möglich, mittels einer "Schicht" von zweiten Kohlenstoff-Nanoröhren 504, 508 jeweils zwei "Schichten" erster Kohlenstoff-Nanoröhren 506 zu steuern, wodurch der benötigte Speicherplatzbedarf des elektronischen Bauelements 500 nur halb so groß ist wie der Speicherplatzbedarf des elektronischen Bauelements 100 gemäß dem ersten Ausführungsbeispiel.

In diesem Dokument sind folgende Veröffentlichungen zitiert:
- [1]: U. Tietze und Z. Schenk, Halbleiterschaltungstechnik, Springer Verlag, 11. Auflage, ISBN 3-540-64192-0, S.751-752, 1999
- [2]: T. Dekker, Carbon-Nanotubes as Molecular Quantum Wires, Physics Today, S. 22-28, Mai 1999
- [3]: Young Sang Suh und Yin Seong Lee, Highly-Ordered Two-Dimensional Carbon-Nanotubes Areas, Applied Physics Letters, Volume 75, Nr. 14, S. 2047-2049, Oktober 1991
- [4]: D. Widmann, H. Mader, H. Friedrich, Technologie hochintegrierter Schaltungen, 2. Auflage, Springer Verlag, ISBN 3-540-59357-8, S. 72 - 75, 1996
- [5]: Ilgweon Kim et al, Room Temperature Single Electron Effects in Si Quantum Dot Memory with Oxide-Nitride Tunneling Dielectrics, IEDM 98, S. 111 - 114, 1998
- [6]: S. Aritome et al, Reliability Issues of Flash Memory Cells, Proceedings of the IEEE, Vol. 81, No. 5, S. 776 - 788, May 1993
- [7]: WO 01/03208 A1

### Bezugszeichenliste

- 100: Elektronisches Bauelement
- 101: Erste Kohlenstoff-Nanoröhre
- 102: Abstand zwischen zwei ersten Kohlenstoff-Nanoröhren
- 103: Schichtensystem
- 104: Erste Siliziumdioxid-Schicht
- 105: Siliziumnitrid-Schicht
- 106: Zweite Siliziumdioxid-Schicht
- 107: Zweite Kohlenstoff-Nanoröhre
- 108: Abstand zwischen zwei zweiten Kohlenstoff-Nanoröhren

- 300: Elektronisches Bauelement
- 301: Erste Kohlenstoff-Nanoröhre
- 302: Abstand zwischen zwei ersten Kohlenstoff-Nanoröhren
- 303: Schichtensystem
- 304: Erste Siliziumdioxid-Schicht
- 305: Zweite Siliziumdioxid-Schicht
- 306: Polysilizium-Quantendots
- 307: Dritte Siliziumdioxid-Schicht
- 308: Zweite Kohlenstoff-Nanoröhre

- 400: Elektronisches Bauelement
- 401: Erste Kohlenstoff-Nanoröhre
- 402: Abstand zwischen zwei ersten Kohlenstoff-Nanoröhren
- 403: Weitere Silizium-Nitrid-Schicht
- 404: Schichtensystem
- 405: Erste Siliziumdioxid-Schicht
- 406: Silizium-Nitrid-Schicht
- 407: Zweite Siliziumdioxid-Schicht
- 408: Zweite Kohlenstoff-Nanoröhre

- 500: Elektronisches Bauelement
- 501: Erste Kohlenstoff-Nanoröhre
- 502: Abstand zwischen zwei ersten Kohlenstoff-Nanoröhren
- 503: Erstes Schichtensystem
- 504: Zweite Kohlenstoff-Nanoröhre
- 505: Zweites Schichtensystem
- 506: Erste Kohlenstoff-Nanoröhre
- 507: Drittes Schichtensystem
- 508: Zweite Kohlenstoff-Nanoröhre

## Patentansprüche

1. Elektronisches Bauelement mit
• mindestens einem elektrisch leitenden ersten Nanodraht,
• mindestens einem auf dem ersten Nanodraht aufgebrachten Schichtensystem,
• mindestens einem auf dem Schichtensystem aufgebrachten zweiten Nanodraht,
• wobei der erste Nanodraht und der zweite Nanodraht zueinander windschief angeordnet sind, und
• wobei das Schichtensystem derart ausgestaltet ist, dass von dem ersten Nanodraht und/oder dem zweiten Nanodraht erzeugte Ladungsträger in dem Schichtensystem gespeichert werden können.

2. Elektronisches Bauelement nach Anspruch 1,
bei dem der zweite Nanodraht elektrisch halbleitend ausgestaltet ist.

3. Elektronisches Bauelement nach Anspruch 1 oder 2,
• mit einer Mehrzahl elektrisch leitender erster Nanodrähte, und
• mit einer Mehrzahl zweiter Nanodrähte,
• wobei die ersten Nanodrähte und die zweiten Nanodrähte jeweils zueinander windschief angeordnet sind.

4. Elektronisches Bauelement nach einem der Ansprüche 1 bis 3,
bei dem der zweite Nanodraht ein Silizium-Nanodraht oder ein Bor-Nitrid Nanodraht ist.

5. Elektronisches Bauelement nach einem der Ansprüche 1 bis 4,
bei dem der erste Nanodraht und/oder der zweite Nanodraht eine bzw. mehrere Kohlenstoff-Nanoröhren sind.

6. Elektronisches Bauelement nach einem der Ansprüche 1 bis 4,
bei dem der erste Nanodraht und/oder der zweite Nanodraht enthalten:
• Gold, und/oder
• Silber, und/oder
• Wolfram, und/oder
• Kupfer, und/oder
• Tantal, und/oder
• Titan.

7. Elektronisches Bauelement nach einem der Ansprüche 1 bis 6,
bei dem das Schichtensystem aufweist:
• eine erste Siliziumdioxid-Schicht,
• eine darauf aufgebrachte Siliziumnitrid-Schicht, und
• eine zweite Siliziumdioxid-Schicht.

8. Elektronisches Bauelement nach Anspruch 7,
bei dem zwischen dem ersten Nanodraht und der ersten Siliziumdioxid-Schicht eine weitere Siliziumnitrid-Schicht vorgesehen ist.

9. Elektronisches Bauelement nach Anspruch 7 oder 8,
bei dem die ersten Nanodrähte und die zweiten Nanodrähte jeweils derart zueinander angeordnet sind, dass der Abstand zwischen zwei ersten Nanodrähten bzw. zwischen zwei zweiten Nanodrähten jeweils mindestens doppelt so groß ist wie der Abstand der ersten Nanodrähte zu der Siliziumnitrid-Schicht.

10. Elektronisches Bauelement nach einem der Ansprüche 1 bis 6,
bei dem das Schichtensystem Quantendots als Störstellen zum Speichern von elektrischen Ladungsträgern aufweist.

11. Elektronisches Bauelement nach Anspruch 10,
bei dem die Quantendots Polysilizium enthalten.

12. Elektronisches Bauelement nach einem der Ansprüche 1 bis 11,
bei dem die ersten Nanodrähte und/oder die zweiten Nanodrähte mehrere zylinderförmige Wände aufweisen.

13. Elektronisches Bauelement nach einem der Ansprüche 1 bis 12,
mit einer Mehrzahl von übereinander angeordneten Schichtensystemen, wobei jeweils zwischen zwei Schichtensystemen abwechselnd ein erster Nanodraht und ein zweiter Nanodraht angeordnet ist.

14. Verfahren zum Herstellen eines elektronischen Bauelements,
• bei dem eine Mehrzahl elektrisch leitender erster Nanodrähte nebeneinander angeordnet werden,
• bei dem mindestens ein Schichtensystem auf den ersten Nanodrähten aufgebracht wird,
• bei dem auf dem Schichtensystem eine Mehrzahl zweiter Nanodrähte nebeneinander und windschief zu den ersten Nanodrähten angeordnet werden.

15. Verfahren nach Anspruch 14,
bei dem der Schritt des Aufbringens des Schichtensystems folgende Schritte aufweist:
• eine erste Siliziumoxid-Schicht wird aufgebracht,
• auf der ersten Siliziumoxid-Schicht wird eine Siliziumnitrid-Schicht aufgebracht,
• auf der Siliziumnitrid-Schicht wird eine Siliziumoxid-Schicht aufgebracht,

16. Verfahren nach Anspruch 15,
bei dem zu Beginn des Aufbringens des Schichtensystems eine weitere Siliziumnitrid-Schicht aufgebracht wird.

17. Verfahren nach einem der Ansprüche 14 bis 16,
bei dem die ersten Nanodrähte und/oder die zweiten Nanodrähte aus der Gasphase abgeschieden werden.

18. Verfahren nach einem der Ansprüche 14 bis 17,
bei dem ein elektrisches Feld zum Anordnen der ersten Nanodrähte und/oder der zweiten Nanodrähte verwendet wird.
